# EUROPEAN PATENT APPLICATION

(11) **EP 4 080 396 A1**
(43) Date of publication of application: **26.10.2022**
(21) Application number: 22176910.2
(22) Date of filing: 09.11.2021
(51) Int. Cl.: G06F 30/13, G06F 30/20

(54) **CONSTRUCTION MANAGEMENT SYSTEM, CONSTRUCTION MANAGEMENT METHOD, AND CONSTRUCTION MANAGEMENT PROGRAM, ACCOMPANIED BY PHYSICAL SIMULATION**

(30) Priority: 16.11.2020 JP 2020190209
(62) Divisional of application: 21207281.3
(71) Applicant: TOPCON CORPORATION, Tokyo 174-8580 (JP)
(72) Inventor: SENOO, Yuki, Tokyo (JP); OKA, Masato, Tokyo (JP); KIUCHI, Masaki, Tokyo (JP); NISHITA, Nobuyuki, Tokyo (JP)
(74) Representative: dompatent von Kreisler Selting Werner - Partnerschaft von Patent- und Rechtsanwälten mbB

(57) **Abstract**

Provided is construction management so that a final form of a structure is as designed. A step of reading a design model (100) of an entire structure from a design database (3), a step of designing an initial construction model (300) so that final form physical simulation results (200) obtained by performing a physical simulation by applying a physical deformation to a model of the structure match the design model, a step of extracting a construction completed part model (400) from the initial construction model, a step of calculating partial physical simulation results (500) obtained by performing the physical simulation for the construction completed part model, a step of obtaining a measurement model (600) from a measurement database (4), a step of calculating an actual object difference (d) by comparing the partial physical simulation results with the measurement model, and a step of instructing construction details of a part to be constructed next and/or later of the initial construction model or an actual object of the structure based on the actual object difference, are performed.

## Description

### [Technical Field]

The present invention relates to a construction management system, method, and program for constructing a structure such as a building.

### [Background Art]

In recent years, for design of a structure in the field of architecture, 3D models called BIM (Building Information Modeling) have been utilized. At a structure construction site, constituent members (for example, posts, beams, and floors, etc.) of the structure are constructed based on design BIM, and whether the respective constituent members have been assembled as designed is inspected by measuring an actual object of the structure constructed. For example, Patent Literature 1 discloses a measuring device for easily and highly accurately measuring a tilt of a structure.

### [Citation List]

### [Patent Literature]

[Patent Literature 1] Japanese Published Unexamined Patent Application No. 2018-179533

### [Summary of Invention]

### [Technical Problem]

In construction of a structure, it is desired that the final form of the structure is as designed. However, as the construction of the structure proceeds, each constituent member deforms due to weight and expands or contracts due to temperature changes, and such a physical deformation is not considered in design BIM. Therefore, even when each floor is constructed as designed, it is difficult to construct the final form as designed, and it is difficult even to correct the deformation of the final form of the structure.

The present invention was made in view of this problem, and an object thereof is to provide a construction management system, method, and program for reviewing construction details in the middle of the construction process by performing a physical simulation by applying a physical deformation to a model of a structure and by considering measurement results of a physical deformation caused by the structure's own weight and a constructed part so that a final form of the structure is as designed.

### [Solution to Problem]

In order to solve the problem described above, a construction management method according to an aspect of the present invention includes the steps of: by transmitting and receiving information to and from a design database storing a design model of a structure and a measurement database storing measurement data on the structure, reading the design model of the entire of the structure from the design database; designing an initial construction model so that final form physical simulation results obtained by performing a physical simulation by applying a physical deformation to a model of the structure match the design model; extracting a construction completed part model of a part completely constructed at the present stage from the initial construction model; calculating partial physical simulation results by performing the physical simulation for the construction completed part model; obtaining a measurement model from the measurement data of the part completely constructed at the present stage in the measurement database; calculating an actual object difference by comparing the partial physical simulation results with the measurement model; and instructing construction details of a part to be constructed next and/or later of the initial construction model or an actual object of the structure based on the actual object difference.

A construction management method according to another aspect of the present invention includes the steps of: by transmitting and receiving information to and from a design database storing a design model of a structure and a measurement database storing measurement data on the structure, reading the design model of the entire structure from the design database; designing an initial construction model so that final form physical simulation results obtained by performing a physical simulation by applying a physical deformation to a model of the structure match the design model; obtaining a measurement model from the measurement data of a part completely constructed at the present stage in the measurement database; creating a synthetic model of the entire of the structure by adding a part not completely constructed at the present stage of the initial construction model to the measurement model of the part completely constructed at the present stage; designing an updated initial construction model from updated final form physical simulation results obtained by performing the physical simulation for the synthetic model; and extracting a part to be constructed next and/or later from the updated initial construction model, and instructing construction details based on the part to be constructed next and/or later of the updated initial construction model.

In the aspect described above, it is also preferable that the step of designing the initial construction model performs either of (i) calculating a design difference between the final form physical simulation results obtained by performing the physical simulation for the design model, and the design model, and by considering the design difference in the design model, designing the initial construction model so that the final form physical simulation results match the design model, or (ii) calculating a design difference between the final form physical simulation results obtained by performing the physical simulation for a temporary initial construction model created based on the design model, and the design model, and by considering the design difference in the design model, designing the initial construction model so that the final form physical simulation results match the design model.

In the aspect described above, it is also preferable that the step of designing the initial construction model includes designing the initial construction model from inverse physical simulation results obtained by performing an inverse physical simulation by inversely transforming the physical simulation for the design model.

In the aspect described above, it is also preferable that the step of obtaining the measurement model includes reading at least one each of measurement data of a lower story reference point and a highest story reference point of the structure as the measurement data.

In order to solve the problem described above, a construction management system according to an aspect of the present invention includes : a design database storing a design model of a structure; a measurement database storing measurement data on the structure; a physical simulation unit configured to perform a physical simulation by applying a physical deformation to a model of the structure; an initial construction database configured to store an initial construction model designed so that final form physical simulation results obtained by performing the physical simulation match the design model; a construction completed part database configured to store a construction completed part model obtained by extracting a part completely constructed at the present stage from the initial construction model; a partial physical simulation results database configured to store partial physical simulation results obtained by performing the physical simulation for the construction completed part model; a comparing unit configured to calculate an actual object difference by comparing the partial physical simulation results with a measurement model obtained from the measurement data of the part completely constructed at the present stage; and a construction instructing unit configured to instruct construction details of a part to be constructed next and/or later of the initial construction model or an actual object of the structure.

A construction management system according to another aspect of the present invention includes: a design database storing a design model of a structure; a measurement database storing measurement data on the structure; a physical simulation unit configured to perform a physical simulation by applying a physical deformation to a model of the structure; an initial construction database configured to store an initial construction model designed so that final form physical simulation results obtained by performing the physical simulation match the design model; an updating unit configured to create a synthetic model of the entire of the structure by adding a part not completely constructed at the present stage of the initial construction model to a measurement model obtained from the measurement data of a part completely constructed at the present stage, and design an updated initial construction model from updated final form physical simulation results obtained by performing the physical simulation for the synthetic model; and a construction instructing unit configured to extract a part to be constructed next and/or later from the updated initial construction model, and instruct construction details based on the part to be constructed next and/or later of the updated initial construction model.

It is also preferable that the construction management method according to the aspect described above is described by a computer program to enable expansion of the construction management method.

### [Effect of Invention]

The present invention provides construction management to obtain a final form of a structure as designed by reviewing construction details in the middle of the construction process by performing a physical simulation by applying a physical deformation to a model of the structure.

### [Brief Description of Drawings]

FIG. 1 is a configuration block diagram of a construction management system according to a first embodiment of the present invention.
FIG. 2 is a flowchart of a construction management method according to the first embodiment of the present invention.
FIG. 3A is a construction management image when construction proceeds as planned in a physical simulation according to its own weight in the flow of FIG. 2.
FIG. 3B is a construction management image when construction proceeds as planned in a physical simulation according to its own weight in the flow of FIG. 2.
FIG. 3C is a construction management image when construction proceeds as planned in a physical simulation according to its own weight in the flow of FIG. 2.
FIG. 3D is a construction management image when construction proceeds as planned in a physical simulation according to its own weight in the flow of FIG. 2.
FIG. 4A is a construction management image when construction deviates from a plan in a physical simulation according to its own weight in the flow of FIG. 2.
FIG. 4B is a construction management image when construction deviates from a plan in a physical simulation according to its own weight in the flow of FIG. 2.
FIG. 4C is a construction management image when construction deviates from a plan in a physical simulation according to its own weight in the flow of FIG. 2.
FIG. 4D is a construction management image when construction deviates from a plan in a physical simulation according to its own weight in the flow of FIG. 2.
FIG. 5A is a construction management image when construction deviates from a plan in a physical simulation according to a temperature change in the flow of FIG. 2.
FIG. 5B is a construction management image when construction deviates from a plan in a physical simulation according to a temperature change in the flow of FIG. 2.
FIG. 5C is a construction management image when construction deviates from a plan in a physical simulation according to a temperature change in the flow of FIG. 2.
FIG. 5D is a construction management image when construction deviates from a plan in a physical simulation according to a temperature change in the flow of FIG. 2.
FIG. 6A is a construction management image when construction proceeds as planned in a physical simulation according to a tilt in the flow of FIG. 2.
FIG. 6B is a construction management image when construction deviates from a plan in a physical simulation according to a tilt in the flow of FIG. 2.
FIG. 7A is a construction management image when marking is performed in a physical simulation according to its own weight in the flow of FIG. 2.
FIG. 7B is a construction management image when marking is performed in a physical simulation according to its own weight in the flow of FIG. 2.
FIG. 7C is a construction management image when marking is performed in a physical simulation according to its own weight in the flow of FIG. 2.
FIG. 7D is a construction management image when marking is performed in a physical simulation according to its own weight in the flow of FIG. 2.
FIG. 8 is a configuration block diagram of a construction management system according to a second embodiment of the present invention.
FIG. 9 is a flowchart of a construction management method according to the second embodiment of the present invention.
FIG. 10 is a construction management image in the flow of FIG. 9. FIG. 11 is a construction management image of Modification 1 according to the embodiment of the present invention.
FIG. 12 is a construction management image of Modification 2 according to the embodiment of the present invention.
FIG. 13 is a construction management image of Modification 3 according to the embodiment of the present invention.

### [Description of Embodiments]

Next, preferred embodiments of the present invention will be described with reference to the drawings.

### First Embodiment:

### <Configuration of Construction Management System>

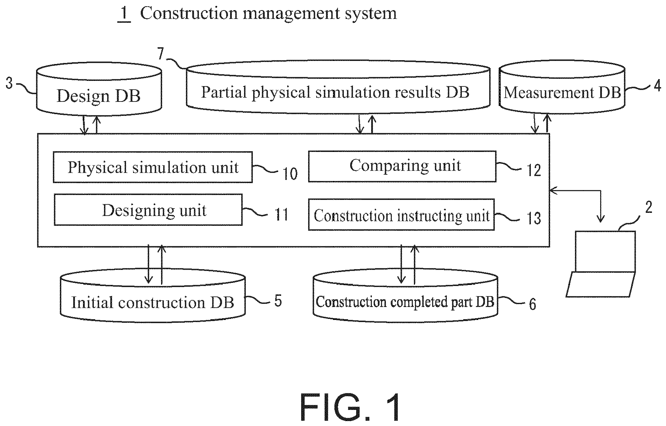

FIG. 1 is a configuration block diagram of a construction management system 1 according to a first embodiment of the present invention. The construction management system 1 includes an input/output device 2, a design database 3, a measurement database 4, an initial construction database 5, a construction completed part database 6, a partial physical simulation results database 7, a physical simulation unit 10, a designing unit 11, a comparing unit 12, and a construction instructing unit 13.

The input/output device 2 is a general-purpose personal computer, a tablet terminal, or the like including at least a computing unit, a storage unit, a communication unit, a display unit, and an operation unit, and can be operated by an administrator.

Each of the functional units of the physical simulation unit 10, the designing unit 11, the comparing unit 12, and the construction instructing unit 13 consists of electronic circuits of a CPU (Central Processing Unit), an ASIC (Application Specific Integrated Circuit), an FPGA (Field Programmable Gate Array) or a PLD (Programmable Logic Device) . Each functional unit is configured inside the input/output device 2 or by either of separate external hardware or software. In the latter case, each functional unit can transmit and receive information to and from the input/output device 2 through a network.

In the design database 3, information on design BIM data of a structure to be constructed (data having a 3D model form of each of constituent members constituting the structure, hereinafter, referred to as a design model) is stored. In the design database 3, information on each constituent member, of at least member identification information (member ID), member coordinates, and a member shape associated with each other are stored.

In the measurement database 4, measurement data of the structure (data with standardized coordinate information) obtained by using a 3D scanner, a total station, a level, a GPS, or the like are stored. It is also preferable that, in order to enable measurement models described later to be extracted on a member-by-member basis, the measurement database 4 has a configuration in which member IDs are assigned to respective points so that which constituent member each point belongs to can be identified.

In the initial construction database 5, information on a 3D model (hereinafter, referred to as an "initial construction model") designed so that "a final form of the structure matches the design model" based on results of a physical simulation described later, is stored.

In the construction completed part database 6, information on a 3D model of only a "part completely constructed" (hereinafter, referred to as a "construction completed part model") extracted from the initial construction model stored in the initial construction database 5, is stored.

In the partial physical simulation results database 7, information on a 3D model of results of a physical simulation performed for the construction completed part model (hereinafter, referred to as "partial physical simulation results"), is stored.

The design database 3, the measurement database 4, the initial construction database 5, the construction completed part database 6, and the partial physical simulation results database 7 are stored in a server computer configured to be capable of making communication through a network. The databases 3 to 7 are associated with each other by the member IDs. The server computer can communicate with the functional units related, and can transmit and receive information to and from the functional units.

The physical simulation unit 10 performs a physical simulation by applying a physical deformation to a model of the structure. In the physical simulation, displacement, stress, and deformation, etc., occurring in each constituent member caused by an external force applied to each constituent member of the structure are calculated, and each constituent member is changed into a form shown by the calculation results. A typical physical simulation is calculation of a deformation of the constitution member caused by a temperature change, calculation of a deformation caused by a tensile load or a compressive load, calculation of a deformation caused by a tilt, or calculation using a finite element method. The physical simulation is not limited to the above-described calculations, and for example, calculations, etc., of ground subsidence, deflection, wind, and moisture content can also be taken into account, and further, a complex simulation combining these calculations is preferably performed. Further, for the constituent members, a simulation according to material properties of an iron member, an aluminum member, concrete, glass, or the like can be performed.

The designing unit 11 compares the design model with results of the physical simulation performed by the physical simulation unit 10, and when there is a difference between the simulation results and the design model, calculates the amount of the difference. Hereinafter, the difference to be calculated by the designing unit 11 is referred to as a "design difference." The designing unit 11 designs an initial construction model based on the design difference.

The comparing unit 12 compares the measurement model with results of the physical simulation of a part corresponding to the measurement model, and when there is a difference between the simulation results and the measurement model, calculates the amount of the difference. Here, the measurement model matches an actual object of the structure at the present stage. Hereinafter, the difference to be calculated by the comparing unit 12 is referred to as an "actual object difference."

Based on the actual object difference, the construction instructing unit 13 instructs construction details of a part to be constructed next and/or later of the initial construction model (the "part to be constructed next and/or later" will be described later) or the actual object of the structure.

Functions of the physical simulation unit 10, the designing unit 11, the comparing unit 12, and the construction instructing unit 13 will be described in greater detail in a construction management method to be described next.

### <Construction Management Method>

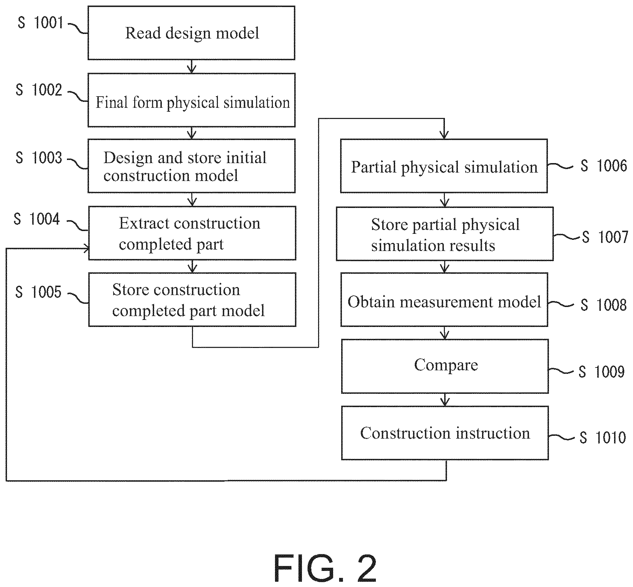

Next, the construction management method using the construction management system 1 described above will be described. FIG. 2 is a flowchart of the construction management method according to the first embodiment of the present invention.

When construction management is started, in Step S1001, the physical simulation unit 10 functions and reads a design model 100 of the entire structure (final form of the structure) from the design database 3.

Next, the processing shifts to Step S1002, and the physical simulation unit 10 performs a physical simulation for the design model 100 (which is an example of "model of the structure" in the claims) of the entire structure (final form of the structure), and calculates physical simulation results 200 of the final form of the structure (hereinafter, referred to as "final form physical simulation results"). The final form physical simulation results 200 show a form different from the design model 100 due to physical deformations such as contractions, deflections, and tilts occurring in the constituent members including posts and beams, etc.

Next, the processing shifts to Step S1003, and the designing unit 11 functions. The designing unit 11 calculates a design difference between the design model 100 and the final form physical simulation results 200, and by considering the design difference in the design model 100, designs an initial construction model 300. Specifically, the designing unit 11 compares the design model 100 and the final form physical simulation results 200 for each constituent member, and when the final form physical simulation results 200 are less than the design model 100, adds the design difference to the design model 100 of the constituent member, and when the final form physical simulation results 200 are more than the design model 100, subtracts the design difference from the design model 100 of the constituent member, and accordingly designs the initial construction model 300 (hereinafter, this work will be referred to as a "design work") . The design work is assumed to be repeated through trial and error, and the design work may be performed multiple times while design difference adjustments are made. By the design work, finally, through a physical simulation performed therefor, the initial construction model 300 has a relationship of matching the design model 100. The initial construction model 300 is stored in the initial construction database 5.

Then, the processing shifts to Step S1004, and the comparing unit 12 functions next. The comparing unit 12 extracts a construction completed part model 400 of "a part completely constructed at the present stage" from the initial construction model 300 stored in the initial construction database 5.

Next, the processing shifts to Step S1005, and the comparing unit 12 stores the construction completed part model 400 extracted in Step S1004 in the construction completed part database 6.

Next, the processing shifts to Step S1006, and the comparing unit 12 causes the physical simulation unit 10 to perform a physical simulation for the construction completed part model 400 and to calculate partial physical simulation results (hereinafter, referred to as "partial physical simulation results") 500 of the structure. When no physical deformation occurs, the partial physical simulation results 500 match the construction completed part model 400, and when a physical deformation occurs, the partial physical simulation results 500 show a form different from the construction completed part model 400.

Next, the processing shifts to Step S1007, and the physical simulation unit 10 stores the partial physical simulation results 500 in the partial physical simulation results database 7.

Next, the processing shifts to Step S1008, and the comparing unit 12 reads measurement data from the measurement database 4, and obtains a measurement model 600 of the structure from the measurement data. The measurement model 600 matches an actual object of the structure at the present stage. The measurement model 600 is created by reading, for example, a measurement data group designated according to information on a date and a time of the measurement, or a measurement data group designated according to an assigned member ID. Alternatively, a measurement model 600 created by a separate device may be obtained by reading through communication.

Next, the processing shifts to Step S1009, and the comparing unit 12 compares the partial physical simulation results 500 obtained in S1006 with the measurement model 600 obtained in Step S1008, and calculates a difference between the simulation results and the actual object, that is, an actual object difference.

As a result of the comparison, when no actual object difference occurs between the partial physical simulation results 500 and the measurement model 600, in Step S1010, the construction instructing unit 13 gives an administrator a construction instruction on construction details that it is allowed to proceed with the construction as designed without change through, for example, a display unit or the like of the input/output device 2. On the other hand, as a result of the comparison, when an actual object difference is found between the partial physical simulation results 500 and the measurement model 600, in Step S1010, the construction instructing unit 13 gives the administrator a construction instruction on construction details to instruct correction by the actual object difference in a "part to be constructed next and/or later of the initial construction model 300" or the "actual object of the structure" through, for example, the display unit or the like of the input/output device 2.

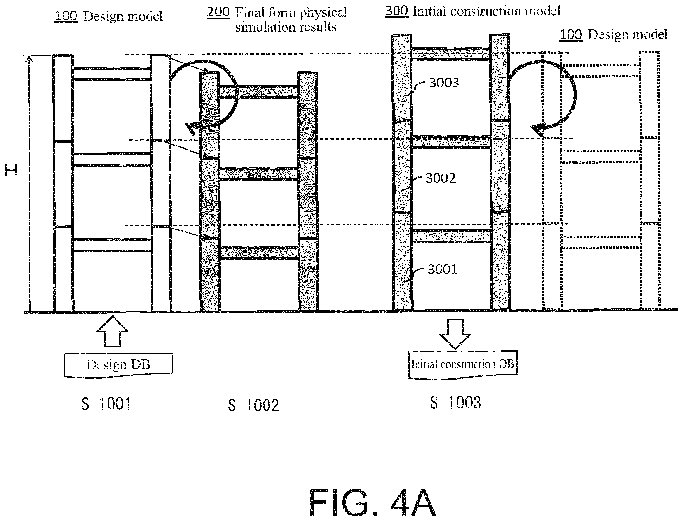

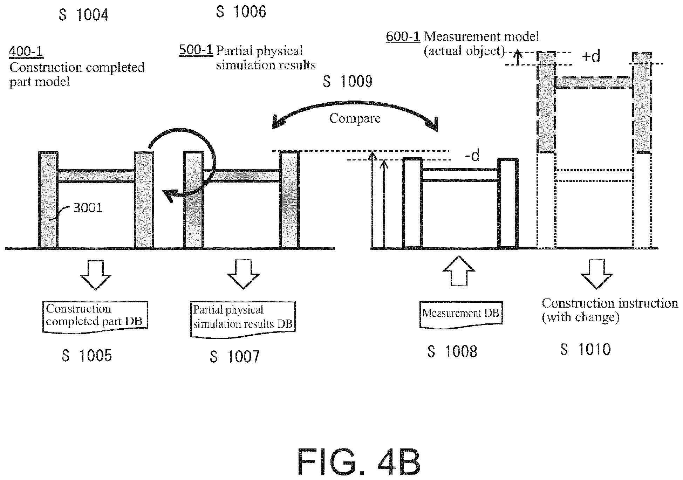

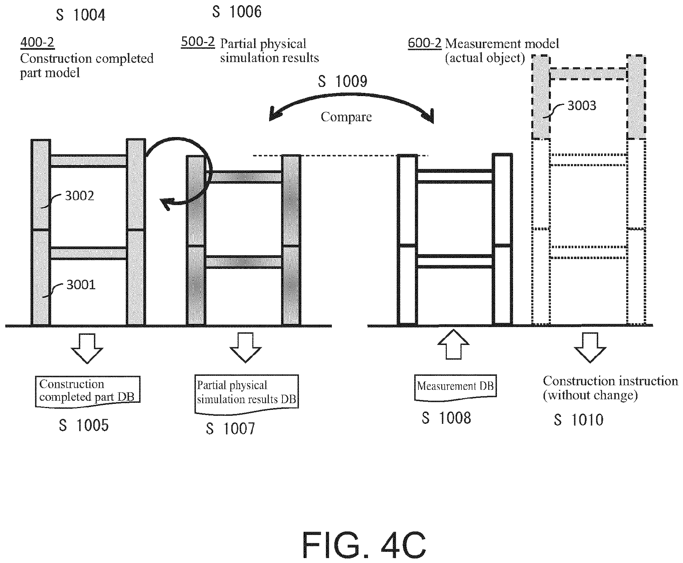

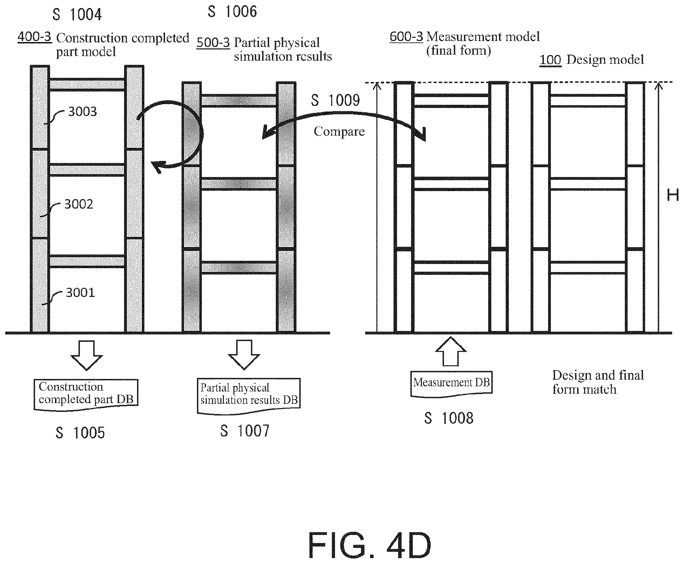

The "part to be constructed next and/or later" means a portion of a part to be constructed subsequent to the part completely constructed at the present stage. For example, in a structure, when the first floor is a part completely constructed at the present stage, a part to be constructed next and/or later includes not only a part (second floor) to be constructed next but also a part (third floor, etc.) to be constructed later. The construction instructing unit 13 instructs construction details to instruct, for example, addition or subtraction of a height corresponding to the actual object difference to or from the part to be constructed next and/or later of the initial construction model 300. The specific "construction details" to the "part to be constructed next and/or later" and "construction details" of the part to be constructed next and/or later will also be described by using the detailed example in FIG. 4.

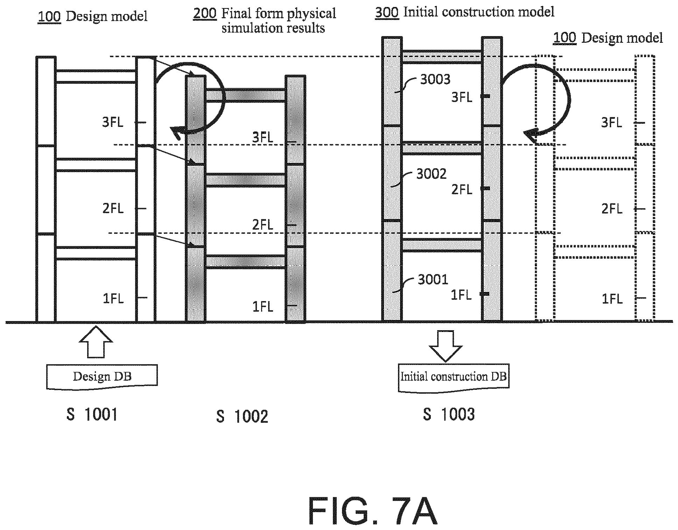

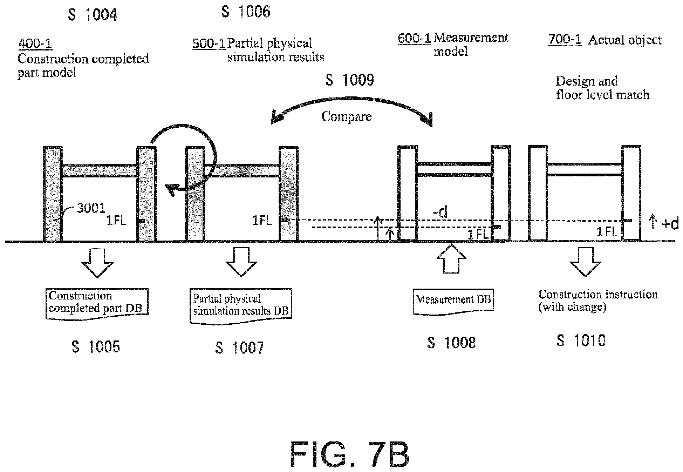

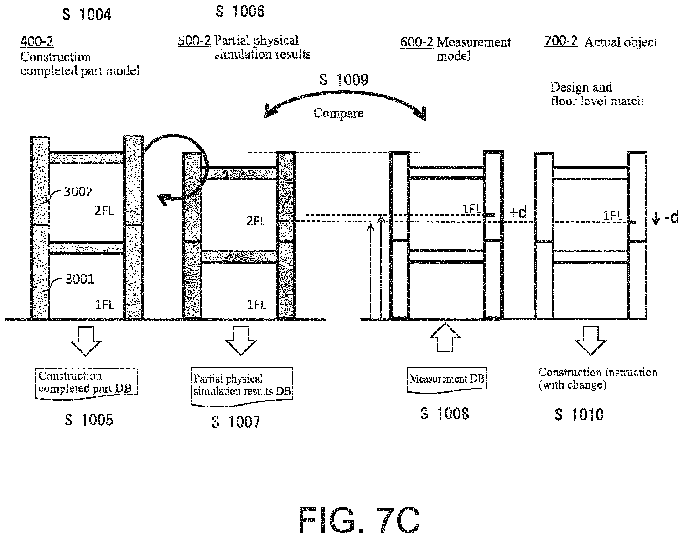

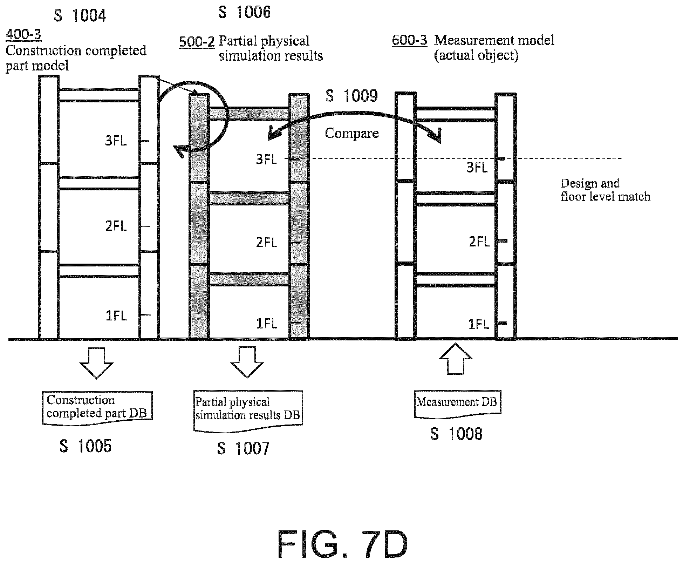

The "actual object of the structure" is the structure itself being constructed. For example, when the first floor is the part completely constructed at the present stage, the "actual object of the structure" is the first floor of the structure. The construction instructing unit 13 instructs construction details to instruct, for example, addition or subtraction of a height corresponding to the actual object difference to or from a height of a construction reference line of the actual object of the structure. The specific "construction details" to the actual object of the structure will also be described by using the detailed example in FIG. 7.

It is also preferable that the construction instruction by the construction instructing unit 13 is given by being accompanied by, for example, an alarm or a heat map display along with a numerical value of the actual object difference on the display unit of the input/output device 2. In addition, it is also preferable that "a permissible value" of the actual object difference is set in advance, and the construction instruction is given when the actual object difference exceeds the permissible value.

In the flow in the construction management method of the present embodiment, after the construction instruction is given in Step S1010, the processing returns to Step S1004. Then, when construction of the part to be constructed next is completed, Steps S1004 to S1010 are performed again, and are repeated until construction of the structure is completed (until the structure is constructed into the final form).

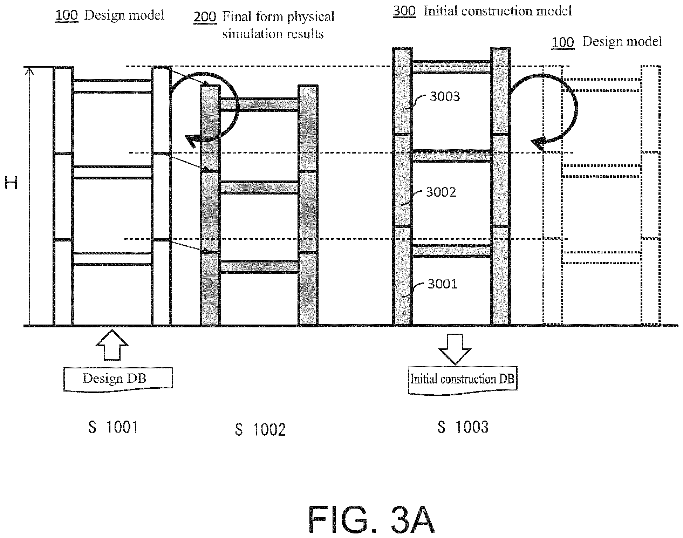

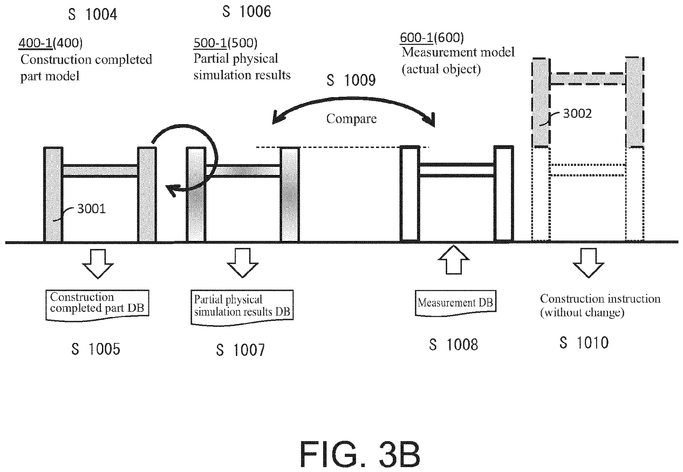

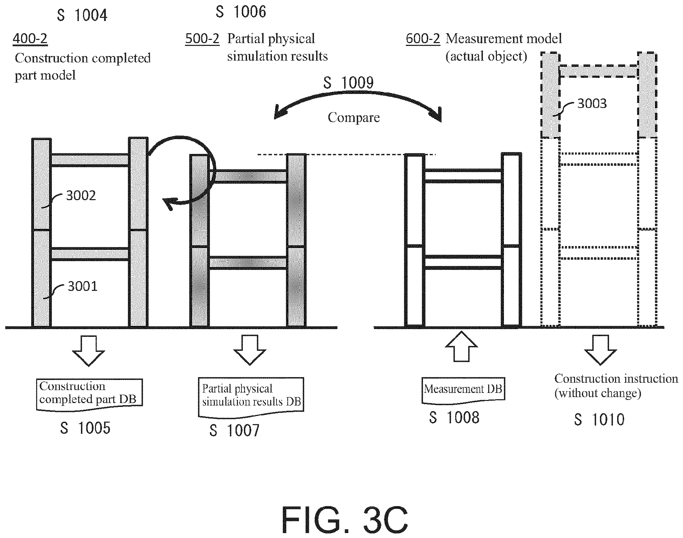

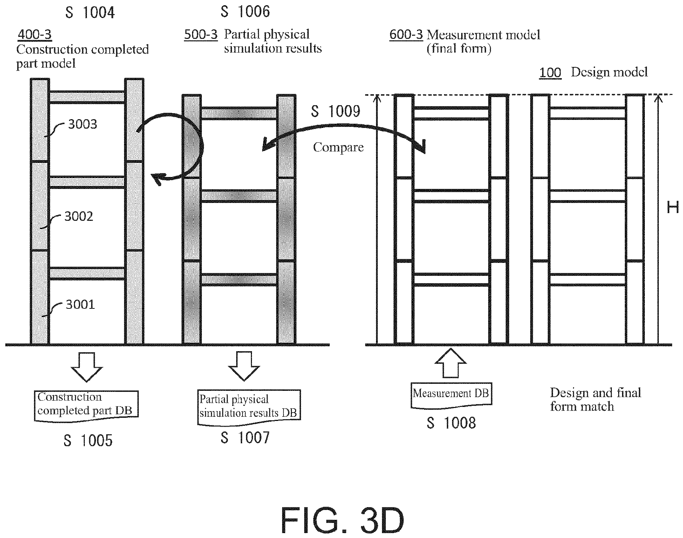

Detailed examples of the construction management method illustrated in FIG. 2 when "the construction proceeds as planned" and when "the construction deviates from the plan" will be described with reference to FIGS. 3 and 4. These examples are described by using a physical simulation in which constituent members are compressively deformed due to their own weight.

### -When construction proceeds as planned-

### (Example of physical simulation according to its own weight)

FIGS. 3A to 3D are construction management images when the construction proceeds as planned in a physical simulation according to its own weight in the flow of Fig. 2. Here, construction of a three-storied structure will be described by way of example. For comprehensive description, a physical deformation is overly represented in the illustration.

When construction management is started, in Step S1001, the physical simulation unit 10 reads a design model 100 of an entire structure (final form of the structure) from the design database 3 (FIG. 3A).

The processing shifts to Step S1002, and the physical simulation unit 10 performs a physical simulation for the design model 100 of the entire structure (final form of the structure), and calculates final form physical simulation results 200 (FIG. 3A). The final form physical simulation results 200 show a form contracted due to its own weight as compared with the height H of the design model 100.

The processing shifts to Step S1003, and the designing unit 11 designs an initial construction model 300 based on a design difference between the design model 100 and the final form physical simulation results 200 (FIG. 3A). The design work may be repeatedly performed. Finally, the initial construction model 300 through the physical simulation, it has a relationship of matching the design model 100. The physical simulation unit 10 stores information on the initial construction model 300 in the initial construction database 5.

### (First floor part)

When construction of the "first floor" is completed, the processing shifts to Step S1004, and the comparing unit 12 extracts a construction completed part model 400 from the initial construction model 300 in the initial construction database 5. As illustrated in FIG. 3B, since the construction of the "first floor" has been completed at the present stage, a first floor part (reference sign 3001 in FIG. 3A) of the initial construction model 300 is extracted as a construction completed part model 400-1 (FIG. 3B) . The processing shifts to Step S1005, and the construction completed part model 400-1 is stored in the construction completed part database 6 (FIG. 3B).

The processing shifts to Step S1006, and the comparing unit 12 causes the physical simulation unit 10 to perform a physical simulation for the construction completed part model 400-1 and to calculate partial physical simulation results 500-1 (FIG. 3B). In this example, since almost no physical deformation occurs in the partial physical simulation results 500-1 of the first floor part substantially, the results 500-1 match the construction completed part model 400-1. The processing shifts to Step S1007, and the partial physical simulation results 500-1 are stored in the partial physical simulation results database 7 (FIG. 3B).

The processing shifts to Step S1008, and the comparing unit 12 obtains a measurement model 600-1 by reading measurement data of the first floor part from the measurement database 4 (FIG. 3B).

The processing shifts to Step S1009, and the comparing unit 12 compares the partial physical simulation results 500-1 with the measurement model 600-1. As a result of the comparison, in this example, a height of the partial physical simulation results 500-1 and a height of the measurement model 600-1 match each other, and no actual object difference occurs.

The processing shifts to Step S1010, and since no actual object difference occurs in the construction of the first floor, the construction instructing unit 13 gives the administrator an instruction that it is allowed to proceed with the construction of a part to be constructed next (second floor part) in accordance with the initial construction without change, that is, on construction details according to the second floor part (reference sign 3002 in FIG. 3A) of the initial construction model 300.

### (Second floor part)

When construction of the "second floor" is completed, the processing shifts to Step S1004 for the second time, and since the construction has been completed up to the "second floor" part at the present stage, the comparing unit 12 extracts the "first and second floor" parts (that is, reference signs 3001 and 3002 in FIG. 3A) of the initial construction model 300 as a construction completed part model 400-2 from the initial construction database 5 (FIG. 3C). The processing shifts to Step S1005, and the construction completed part model 400-2 is stored in the construction completed part database 6 (FIG. 3C).

The processing shifts to Step S1006, and the comparing unit 12 causes the physical simulation unit 10 to perform a physical simulation for the construction completed part model 400-2 and to calculate partial physical simulation results 500-2 (FIG. 3C) . In this example, in the partial physical simulation results 500-2, the first floor part slightly contracts due to the weight of the second floor part. The processing shifts to Step S1007, and the physical simulation unit 10 stores the partial physical simulation results 500-2 in the partial physical simulation results database 7 (FIG. 3C) .

The processing shifts to Step S1008, and the comparing unit 12 obtains a measurement model 600-2 by reading measurement data corresponding to the first and second floor parts from the measurement database 4 (FIG. 3C) . The processing shifts to Step S1009 and the comparing unit 12 compares the partial physical simulation results 500-2 with the measurement model 600-2. As a result of the comparison, in this example, a height of the partial physical simulation results 500-2 and a height of the measurement model 600-2 match each other, and no actual object difference occurs.

Next, the processing shifts to Step S1010, and since no actual object difference occurs also in the construction of the second floor, the construction instructing unit 13 gives the administrator an instruction that it is allowed to proceed with the construction of a part to be constructed next (third floor part) in accordance with the initial construction without change, that is, on construction details according to the third floor part (reference sign 3003 in FIG. 3A) of the initial construction model 300.

### (Third floor part)

When construction of the "third floor" is completed, the processing shifts to Step S1004 for the third time, and the comparing unit 12 extracts the "first, second, and third floor" parts (that is, the reference signs 3001, 3002, and 3003 in FIG. 3A) of the initial construction model 300 as a construction completed part model 400-3 from the initial construction database 5 (FIG. 3D). The processing shifts to Step S1005, and the construction completed part model 400-3 is stored in the construction completed part database 6 (FIG. 3D).

The processing shifts to Step S1006, and the comparing unit 12 causes the physical simulation unit 10 to perform a physical simulation for the construction completed part model 400-3 and to calculate partial physical simulation results 500-3 (FIG. 3D). In this example, the second floor part slightly contracts due to the weight of the third floor, and the first floor part further contracts due to the weight of the second and third floors. The processing shifts to Step S1007, and the physical simulation unit 10 stores the partial physical simulation results 500-3 in the partial physical simulation results database 7 (FIG. 3D).

Next, the processing shifts to Step S1008, and the comparing unit 12 obtains a measurement model 600-3 by reading measurement data corresponding to the first, second, and third floor parts from the measurement database 4. The processing shifts to Step S1009, and the comparing unit 12 compares the partial physical simulation results 500-3 with the measurement model 600-3. As a result of the comparison, in this example, a height of the partial physical simulation results 500-3 and a height of the measurement model 600-3 match each other, and no actual object difference occurs.

Here, the measurement model 600-3 in Step S1009 is the final form of the structure. That is, in the middle of the construction process, the physical simulation results (partial physical simulation results 500) are compared with the actual object (measurement model 600) to proceed with construction so that the final form of the structure always matches the design model 100, and the construction in which a height of the final form (measurement model 600-3) of the structure matches a height H of the design model 100 can be performed.

### -When construction deviates from plan-

### (Example of physical simulation according to its own weight)

FIGS. 4A to 4D are construction management image views when construction deviates from a plan in a physical simulation according to its own weight in the flow of FIG. 2. As in FIG. 3, also in FIG. 4, construction of a three-storied structure is described by way of example, and a physical deformation is overly illustrated.

When construction management is started, as in FIG. 3, in Step S1001, the physical simulation unit 10 reads a design model 100 of the entire structure (final form of the structure) from the design database 3 (FIG. 4A), and the processing shifts to Step S1002, and the physical simulation unit 10 performs a physical simulation for the design model 100 of the entire structure and calculates final form physical simulation results 200 (FIG. 4A) . The final form physical simulation results 200 show a form contracted due to its own weight as compared with the height H of the design model. The processing shifts to Step S1003, and the designing unit 11 calculates a design difference between the design model 100 and the final form physical simulation results 200, and designs an initial construction model 300 by adding the design difference to the design model 100 (FIG. 4A) . The design work may be repeatedly performed. Finally, the initial construction model 300 through the physical simulation, it has a relationship of matching the design model 100. The physical simulation unit 10 stores information on the initial construction model 300 in the initial construction database 5.

### (First floor part)

When construction of the "first floor" is completed, the processing shifts to Step S1004, and the comparing unit 12 extracts the "first floor" part (reference sign 3001 in FIG. 4A) of the initial construction model 300 as a construction completed part model 400-1 from the initial construction database 5 (FIG. 4B). The processing shifts to Step S1005, and the construction completed part model 400-1 is stored in the construction completed part database 6 (FIG. 4B).

The processing shifts to Step S1006, and the comparing unit 12 causes the physical simulation unit 10 to perform a physical simulation for the construction completed part model 400-1 and to calculate partial physical simulation results 500-1 (FIG. 4B). In this example, since almost no physical deformation occurs in the partial physical simulation results 500-1 of the first floor part, the results 500-1 substantially match the construction completed part model 400-1. The processing shifts to Step S1007, and the partial physical simulation results 500-1 are stored in the partial physical simulation results database 7 (FIG. 4B).

The processing shifts to Step S1008, and the comparing unit 12 obtains a measurement model 600-1 by reading measurement data of the first floor part from the measurement database 4 (FIG. 4B).

The processing shifts to Step S1009, and the comparing unit 12 compares the partial physical simulation results 500-1 with the measurement model 600-1. As a result of the comparison, it is assumed in this example that, as an actual object difference, a height of the measurement model 600-1 is lower by "d" than the partial physical simulation results 500-1 (FIG. 4B).

In this case, when the processing shifts to Step S1010, the construction instructing unit 13 gives the administrator an instruction on construction details to instruct correction by the actual object difference d in a "part to be constructed next and/or later." In this example, it is assumed that correction by the actual object difference d is made in the "part to be constructed next (second floor)," and construction details are given to instruct addition of a height corresponding to the actual object difference d to the second floor part (reference sign 3002 in FIG. 4A) of the initial construction model 300. As an example, an instruction is considered to make longer a steel frame length for the second floor part, or insert a dimensional adjustment member between steel frames.

The actual object difference d is not limited to the correction in the part to be constructed next (second floor part in this example), and may be a correction in a part to be constructed later (third floor part in this example), or may be a correction in a divided manner in the respective parts to be constructed next and later (the second and third floor parts in this example) . That is, the correction by the actual object difference d only has to be made in these parts which all belong to the "part to be constructed next and/or later. " The part to be constructed next and/or later is not limited to a floor-by-floor basis, and a plurality of floors may be regarded as a unit part, or construction points on the same floor may be regarded as a unit part.

### (Second floor part)

When construction of the "second floor" is completed according to the construction instruction, the processing shifts to Step S1004 for the second time, and the comparing unit 12 extracts the "first and second floor" parts (that is, reference signs 3001 and 3002 in FIG. 4A) of the initial construction model 300 as a construction completed part model 400-2 from the initial construction database 5 (FIG. 4C). The processing shifts to Step S1005, and the construction completed part model 400-2 is stored in the construction completed part database 6 (FIG. 4C).

The processing shifts to Step S1006, and the comparing unit 12 causes the physical simulation unit 10 to perform a physical simulation for the construction completed part model 400-2 and to calculate partial physical simulation results 500-2 (FIG. 4C) . In this example, in the partial physical simulation results 500-2, the first floor part slightly contracts due to the weight of the second floor part. The processing shifts to Step S1007, and the physical simulation unit 10 stores the partial physical simulation results 500-2 in the partial physical simulation results database 7 (FIG. 4C) .

The processing shifts to Step S1008, and the comparing unit 12 obtains a measurement model 600-2 by reading measurement data corresponding to the first and second floor parts after the construction of the second floor from the measurement database 4 (FIG. 4C). The processing shifts to Step S1009, and the comparing unit 12 compares the partial physical simulation results 500-2 with the measurement model 600-2. As a result of the comparison, a height of the results 500-2 and a height of the model 600-2 match each other, and no actual object difference occurs.

The processing shifts to Step S1010, and since no actual object difference occurs in the construction up to the second floor, the construction instructing unit 13 gives the administrator an instruction that it is allowed to proceed with construction of a part to be constructed next (third floor part) in accordance with the initial construction without change, that is, on construction details according to the third floor part (reference sign 3003 in FIG. 4A) of the initial construction model 300.

### (Third floor part)

When construction of the third floor part is completed, the processing shifts to Step S1004 for the third time, and the comparing unit 12 extracts the "first, second, and third floor" parts (that is, reference signs 3001, 3002, and 3003 in FIG. 4A) of the initial construction model 300 as a construction completed part model 400-3 from the initial construction database 5 (FIG. 4D). The processing shifts to Step S1005, and the construction completed part model 400-3 is stored in the construction completed part database 6 (FIG. 4D).

The processing shifts to Step S1006, and the comparing unit 12 causes the physical simulation unit 10 to perform a physical simulation for the construction completed part model 400-3 and to calculate partial physical simulation results 500-3 (FIG. 4D). In this example, the second floor part slightly contracts due to the weight of the third floor, and the first floor part further contracts due to the weight of the second floor and the third floor. The processing shifts to Step S1007, and the physical simulation unit 10 stores the partial physical simulation results 500-3 in the partial physical simulation results database 7 (FIG. 4D).

The processing shifts to Step S1008, and the comparing unit 12 creates a measurement model 600-3 by reading measurement data corresponding to the first, second, and third floor parts from the measurement database 4 (FIG. 4D). The processing shifts to Step S1009, and the comparing unit 12 compares the partial physical simulation results 500-3 with the measurement model 600-3. As a result of the comparison, in this example, a height of the partial physical simulation results 500-3 and a height of the measurement model 600-3 match each other, and no actual object difference occurs.

Here, the measurement model 600-3 in Step S1009 is a final form of the structure. That is, in the middle of the construction process, the physical simulation results (partial physical simulation results 500) are compared with the actual object (measurement model 600), and when an actual object difference d occurs, a construction instruction to resolve this difference in a part to be constructed next and/or later is given, and accordingly, construction in which the height of the final form (measurement model 600-3) of the structure matches the height H of the design model 100 can be performed.

As described above, as shown from both of the patterns illustrated in FIGS. 3 and 4, in the construction management system 1 and the construction management method of the present embodiment, when starting construction, an initial construction model 300 is designed so that physical simulation results of the final form (final form physical simulation results 200) of the structure are as designed (design model 100), and based on the initial construction model 300, the construction is started. Then, in the middle of the construction process, the physical simulation results (partial physical simulation results 500) and the actual object (measurement model 600) are compared with each other, and when no actual object difference d occurs, construction details based on the initial construction model 300 are instructed, and when an actual object difference d occurs, construction details for resolving this difference in a part to be constructed next and/or later are instructed. According to these construction instructions, the construction proceeds so that the final form of the structure always matches the design model 100, and therefore, construction management can be performed so that the final form of the structure finally is as designed.

### (Example of physical simulation according to temperature change)

Next, the construction management method illustrated in FIG. 2 will be described by using a physical simulation in which constituent members expand or contract due to a temperature change.

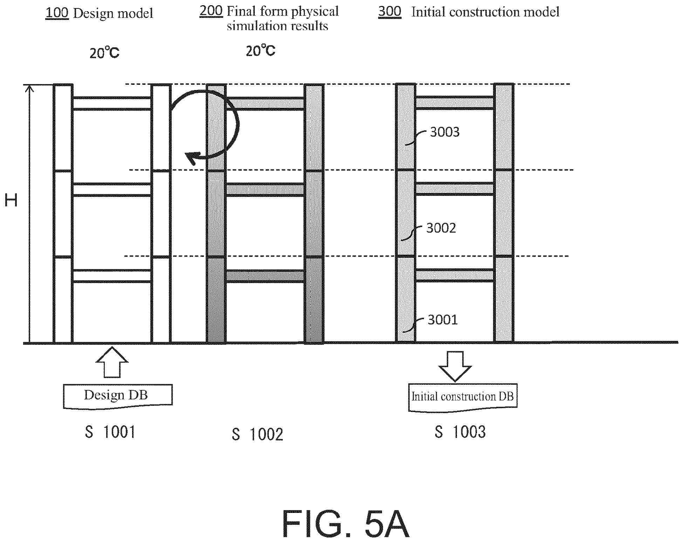

FIGS. 5A to 5D are configuration management images when the construction deviates from a plan in a physical simulation according to a temperature change in the flow of Fig. 2. Also here, construction of a three-storied structure is described by way of example, and a physical deformation is overly illustrated. A design model 100 is assumed to be designed at an air temperature of 20°C.

When construction management is started, in Step S1001, the physical simulation unit 100 reads a design model 100 of the entire structure (final form of the structure) from the design database 3 (FIG. 5A).

The processing shifts to Step S1002, and the physical simulation unit 10 performs a physical simulation for the design model 100 of the entire structure (final form of the structure) at a planned temperature (for example, annual mean temperature at the construction site. The planned temperature can be set to a temperature that an administrator thinks appropriate.), and calculates final form physical simulation results 200 (FIG. 5A). In this example, since the planned air temperature is set to 20°C as in the design, there is almost no deformation in the final physical simulation results 200.

The processing shifts to Step S1003, and the designing unit 11 calculates a design difference between the design model 100 and the final form physical simulation results 200. In this example, since there is almost no deformation in Step S1002, the design model 100 is stored without change as information on the initial construction model 300 in the initial construction database 5 (FIG. 5A).

### (First floor part)

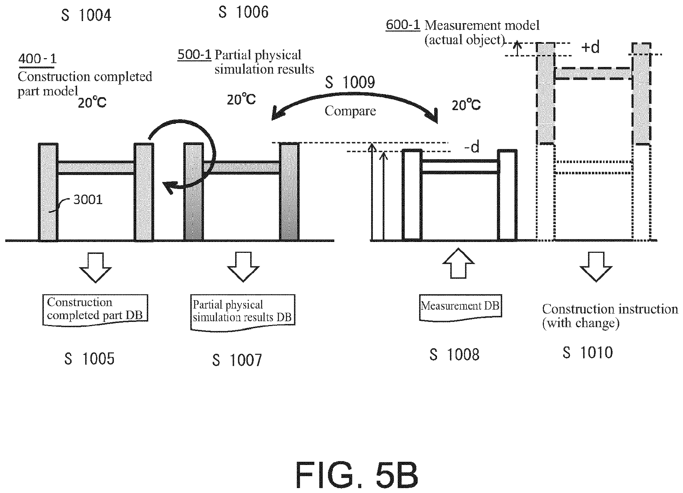

The processing shifts to Step S1004, and the comparing unit 12 extracts a "first floor" part (reference sign 3001 in FIG. 5A) of the initial construction model 300 as a construction completed part model 400-1 from the initial construction database 5 (FIG. 5B). The processing shifts to Step S1005, and the construction completed part model 400-1 is stored in the construction completed part database 6 (FIG. 5B).

The processing shifts to Step S1006, and the comparing unit 12 causes the physical simulation unit 10 to perform a physical simulation at the same air temperature (set to 20°C in this example) as that when measurement data of the first floor was obtained, and to calculate partial physical simulation results 500-1 (FIG. 5B). The processing shifts to Step S1007, and the partial physical simulation results 500-1 are stored in the partial physical simulation results database 7 (FIG. 5B).

The processing shifts to Step S1008, and the comparing unit 12 obtains a measurement model 600-1 by reading measurement data of the first floor part from the measurement database 4 (FIG. 5B).

The processing shifts to Step S1009, and the comparing unit 12 compares the partial physical simulation results 500-1 with the measurement model 600-1. As a result of the comparison, it is assumed in this example that, as an actual object difference, a height of the measurement model 600-1 is lower by "d" than the partial physical simulation results 500-1 (FIG. 5B).

The processing shifts to Step S1010, and the construction instructing unit 13 instructs construction details to instruct correction by the actual object difference d in a part to be constructed next and/or later (second floor part in this example), specifically, addition of a height corresponding to the actual object difference "d" to the second floor part (reference sign 3002 in FIG. 5A) of the initial construction model 300.

### (Second floor part)

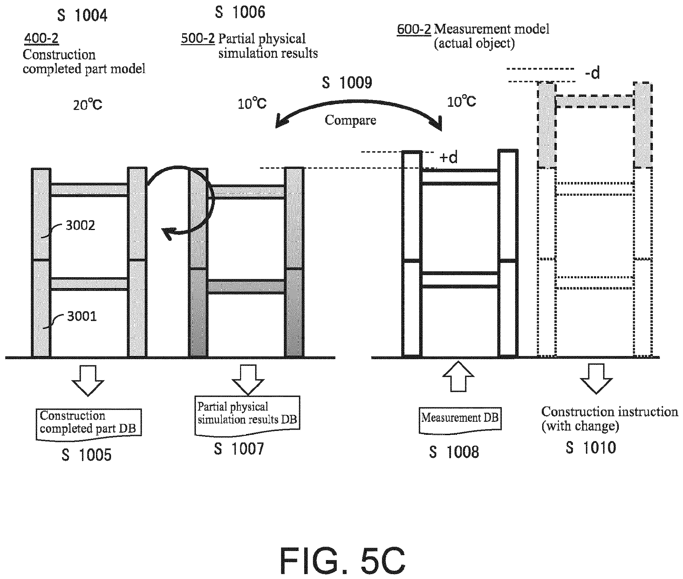

When construction of the "second floor" is completed according to the construction instruction, the processing shifts to Step S1004 for the second time, and the comparing unit 12 extracts the "first and second floor" parts (reference signs 3001 and 3002 in FIG. 5A) of the initial construction model 300 as a construction completed part model 400-2 from the initial construction database 5 (FIG. 5C). The processing shifts to Step S1005, and the construction completed part model 400-2 is stored in the construction completed part database 6 (FIG. 5C).

The processing shifts to Step S1006, and the comparing unit 12 causes the physical simulation unit 10 to perform a physical simulation for the construction completed part model 400-2 at the same air temperature (set to 10°C) as that when the measurement data of the second floor was obtained, and to calculate partial physical simulation results 500-2 (FIG. 5C). In FIG. 5C, constituent members contract due to an air temperature decrease, and the partial physical simulation results 500-2 show a slight contraction as compared with the construction completed part model 400-2. The processing shifts to Step S1007, and the partial physical simulation results 500-2 are stored in the partial physical simulation results database 7 (FIG. 5C).

The processing shifts to Step S1008, and the comparing unit 12 obtains a measurement model 600-2 by reading measurement data corresponding to first and second floor parts after the construction of the second floor from the measurement database 4 (FIG. 5C).

The processing shifts to Step S1009, and the comparing unit 12 compares the partial physical simulation results 500-2 with the measurement model 600-2. As a result of the comparison, it is assumed in this example that, as an actual object difference, a height of the measurement model 600-2 is higher by "d" than the partial physical simulation results 500-2 (FIG. 5C).

In this case, when the processing shifts to Step S1010, the construction instructing unit 13 instructs construction details to instruct correction by the actual object difference d in a part to be constructed next and/or later (third floor part in this example), specifically, subtraction of a height corresponding to the actual object difference "d" from a third floor part (reference sign 3003 in FIG. 5A) of the initial construction model 300. As an example, an instruction is considered to make shorter a steel frame length for the third floor part.

### (Third floor part)

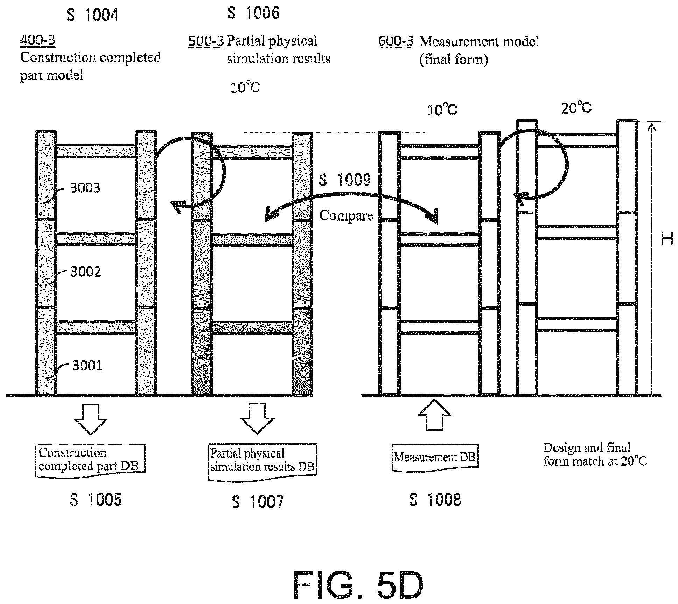

When construction of the third floor is completed according to the construction instruction, the processing shifts to Step S1004 for the third time, and the comparing unit 12 extracts the "first, second, and third floor" parts (that is, reference signs 3001, 3002, and 3003 in FIG. 5A) of the initial construction model 300 as a construction completed part model 400-3 from the initial construction database 5 (FIG. 5D). The processing shifts to Step S1005, and the construction completed part model 400-3 is stored in the construction completed part database 6 (FIG. 5D).

The processing shifts to Step S1006, and the comparing unit 12 causes the physical simulation unit 10 to perform a physical simulation for the construction completed part model 400-3 at the same air temperature (set to 10°C) as that when the measurement data of the third floor was obtained, and to calculate partial physical simulation results 500-3 (FIG. 5D). In this example, in the partial physical simulation results 500-3, constituent members contract due to an air temperature decrease, and the partial physical simulation results 500-3 show a slight contraction as compared with the construction completed part model 400-3. In Step S1007, the partial physical simulation results 500-3 are stored in the partial physical simulation results database 7 (FIG. 5D).

The processing shifts to Step S1008, and the comparing unit 12 obtains a measurement model 600-3 by reading measurement data corresponding to the first, second, and third floor parts after the construction of the third floor from the measurement database 4 (FIG. 5D).

The processing shifts to Step S1009, and the comparing unit 12 compares the partial physical simulation results 500-3 with the measurement model 600-3. As a result of the comparison, in this example, a height of the partial physical simulation results 500-3 (10°C) and a height of the measurement model 600-3 (10°C) match each other, and no actual object difference occurs.

Here, the measurement model 600-3 in Step S1009 is a final form of the structure. The initial construction model 300 matches the original design (design model 100) through a physical simulation performed at the same temperature as that at the time of design, and therefore, the final form of the structure the height of which matches a height of the partial physical simulation results 500-3 at the temperature of 10°C at the time of measurement, matches the height H of the design model 100 even at the temperature of 20°C at the time of design. Therefore, according to the construction management system 1 and the construction management method of the present embodiment, even in a physical simulation according to a temperature change, construction management can be performed so that a final form of the structure is as designed.

In this example, for simple description, description is given by using member expansion and contraction in the vertical direction, however, member expansion and contraction in the horizontal direction on the assumption of a constituent member such as a beam is also included in an actual simulation.

### (Example of physical simulation according to tilt)

Next, the construction management method illustrated in FIG. 2 will be described by using a physical simulation according to a tilt of constituent members.

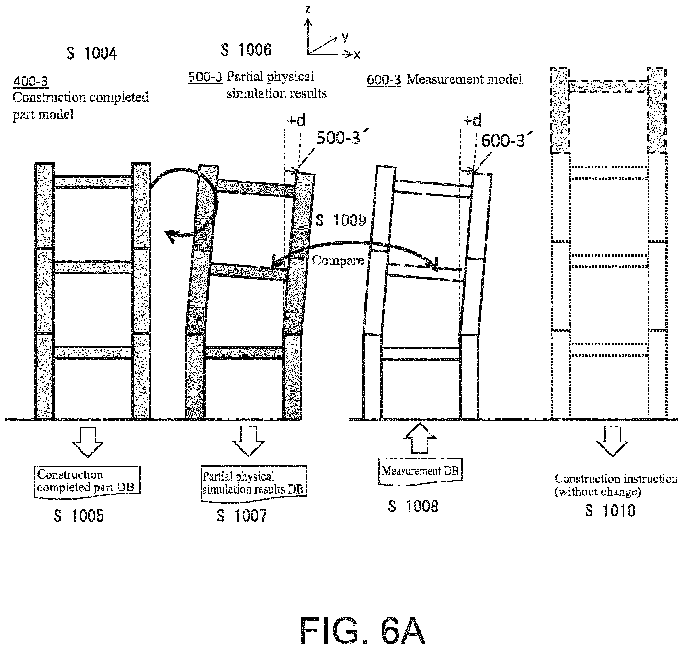

FIG. 6A is a construction management image when construction proceeds as planned in a physical simulation according to a tilt in the flow of FIG. 2. In FIG. 6A, on the assumption that construction has been completed up to the third floor, construction of the fourth floor is illustrated by way of example, and a physical deformation is overly illustrated.

When construction management is started, in Step S1001, the physical simulation unit 10 reads a design model 100 (not illustrated) of the entire structure (final form of the structure) from the design database 3. The processing shifts to Step S1002, and the physical simulation unit 10 performs a physical simulation by applying a tilt to constituent members in consideration of sunlight for the design model 100 of the entire structure (final form of the structure), and calculates final form physical simulation results 200 (not illustrated). The processing shifts to Step S1003, and the designing unit 11 calculates a design difference between the design model 100 and the final form physical simulation results 200. In this example, it is assumed that there is almost no deformation in Step S1002, and the design model 100 is stored without change as information on the initial construction model 300 in the initial construction database 5 (not illustrated).

The processing shifts to Step S1004, and the comparing unit 12 extracts a part up to the third floor part of the initial construction model 300 as a construction completed part model 400-3 from the initial construction database 5 (FIG. 6A). In Step S1005, the construction completed part model 400-3 is stored in the construction completed part database 6 (FIG. 6A).

The processing shifts to Step S1006, and the comparing unit 12 causes the physical simulation unit 10 to perform a physical simulation for the construction completed part model 400-3 and to calculate partial physical simulation results 500-3 (FIG. 6A). In this example, it is assumed that some of the constituent members have deformed due to sunlight and caused a tilt in the structure of the second and third floors (three-dimensional displacement due to the tilt), and for example, a displacement of "+d" has occurred in the X direction at an upper end portion 500-3' of the partial physical simulation results 500-3. In Step S1007, the partial physical simulation results 500-3 are stored in the partial physical simulation results database 7 (FIG. 6A).

The processing shifts to Step S1008, and the comparing unit 12 obtains a measurement model 600-3 of a part up to the third floor part from the measurement database 4, and then, the processing shifts to Step S1009, and the comparing unit 12 compares the partial physical simulation results 500-3 with the measurement model 600-3. As a result of the comparison, in this example, it is assumed that both of the upper end portion 500-3' of the partial physical simulation results 500-3 and an upper end portion 600-3' of the measurement model 600-3 have been displaced by "+d" in the X direction, and no actual object difference has occurred. Since no actual object difference has occurred, the processing shifts to Step S1010, and the construction instructing unit 13 gives an instruction on construction details of the fourth floor part of the initial construction model 300, for a "fourth floor" part to be constructed next.

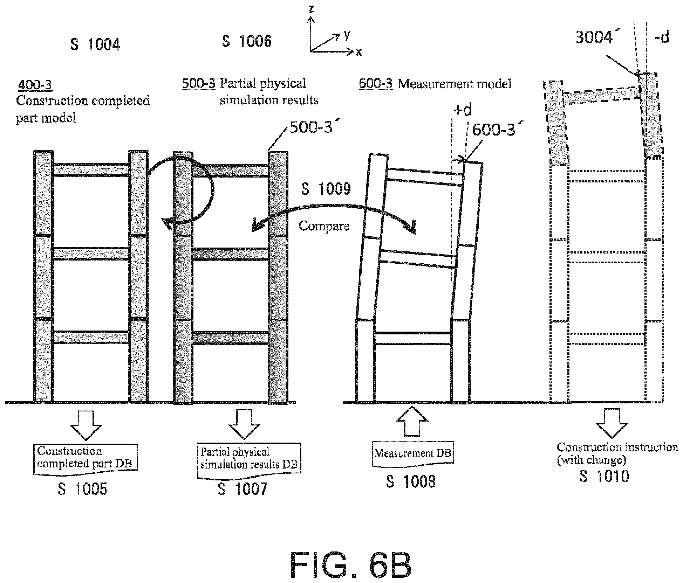

FIG. 6B is a construction management image when construction deviates from a plan in a physical simulation according to a tilt in the flow of FIG. 2. As in the description above, on the assumption that construction has been completed up to the third floor, construction of the fourth floor is illustrated by way of example, and a physical deformation is overly illustrated.

Steps S1001 to S1003 are performed in the same manner as described above (not illustrated), and the processing shifts to Step S1004, and the comparing unit 12 extracts a part up to the third floor part of the initial construction model 300 as a construction completed part model 400-3 from the initial construction database 5 (FIG. 6B). In Step S1005, the construction completed part model 400-3 is stored in the construction completed part database 6 (FIG. 6B).

The processing shifts to Step S1006, and the comparing unit 12 causes the physical simulation unit 10 to perform a physical simulation for the construction completed part model 400-3 and to calculate partial physical simulation results 500-3 (FIG. 6B). In this example, it is assumed that the partial physical simulation results 500-3 are obtained through a simulation on the assumption that substantially no deformation of constituent members due to sunlight occurs. In Step S1007, the partial physical simulation results 500-3 are stored in the partial physical simulation results database 7 (FIG. 6B).

The processing shifts to Step S1008, the comparing unit 12 obtains a measurement model 600-3 up to the third floor part from the measurement database 4, and then, the processing shifts to Step S1009, and the comparing unit 12 compares the partial physical simulation results 500-3 with the measurement model 600-3. As a result of the comparison, in this example, it is assumed that the measurement model 600-3 has tilted as compared with the partial physical simulation results 500-3, and the upper end portion 600-3' of the measurement model 600-3 has been displaced by "+d" in the X direction as compared with the upper end portion 500-3' of the partial physical simulation results 500-3 (FIG. 6B).

In this case, when the processing shifts to Step S1010, the construction instructing unit 13 instructs, for the "fourth floor" part to be constructed next, construction details to instruct displacement of an upper end portion 3004' of the fourth floor part of the initial construction model 300 by the actual object difference "-d" in the X direction.

As described above, according to the construction management system 1 and the construction management method of the present embodiment, in the middle of the construction process, the physical simulation results (partial physical simulation results 500) and the actual object (measurement model 600) are compared with each other, and when an actual object difference d occurs, construction proceeds so as to eliminate the tilt in a part to be constructed next and/or later, so that even in a physical simulation according to a tilt of constituent members, construction management can be performed so that the final form of the structure is as designed.

For simple description, a displacement caused by a tilt is described only in the X direction, however, in an actual simulation, displacements in the Y and Z directions are also included.

### (Application example of physical simulation according to its own weight)

FIGS. 7A to 7D are construction management images when marking is performed in a physical simulation according to its own weight. As in the description above, construction of a three-storied structure is illustrated by way of example, and a physical deformation is overly illustrated.

When construction management is started, in Step S1001, the physical simulation unit 10 reads information on a design model 100 of the entire structure (final form of the structure) and each marking line (floor level) FL from the design database 3 (FIG. 7A).

The processing shifts to Step S1002, and the physical simulation unit 10 performs a physical simulation for the design model 100 of the entire structure, and calculates final form physical simulation results 200 (FIG. 7A). The final form physical simulation results 200 show contraction caused by its own weight and the positions of marking lines 1FL, 2FL, and 3FL of the respective floors that have also lowered.

The processing shifts to Step S1003, and the designing unit 11 calculates a design difference between the design model 100 and the final form physical simulation results 200, and designs an initial construction model 300 and respective marking lines 1FL, 2FL, and 3FL by adding the design difference to the design model 100 (FIG. 7A). The design work by the designing unit 11 may be repeatedly performed. Finally, through a physical simulation performed therefor, the respective marking lines 1FL, 2FL, and 3FL of the initial construction model 300 have a relationship of matching the respective marking lines 1FL, 2FL, and 3FL of the design model 100. The physical simulation unit 10 stores information on the initial construction model 300 in the initial construction database 5.

### (First floor part)

When construction of the "first floor" is completed, the processing shifts to Step S1004, and the comparing unit 12 extracts the "first floor" part (reference sign 3001 in FIG. 7A) of the initial construction model 300 as a construction completed part model 400-1 from the initial construction database 5 (FIG. 7B). The processing shifts to Step S1005, and the comparing unit 12 stores the construction completed part model 400-1 in the construction completed part database 6 (FIG. 7B).

The processing shifts to Step S1006, and the comparing unit 12 causes the physical simulation unit 10 to perform a physical simulation for the construction completed part model 400-1 and to calculate partial physical simulation results 500-1 and a marking line 1FL of the results 500-1 (FIG. 7B). In this example, almost no physical deformation occurs in the partial physical simulation results 500-1 of the first floor. The processing shifts to Step S1007, and the partial physical simulation results 500-1 are stored in the partial physical simulation results database 7 (FIG. 7B).

The processing shifts to Step S1008, and the comparing unit 12 obtains a measurement model 600-1 by reading measurement data of the first floor part from the measurement database 4 (FIG. 7B).

The processing shifts to Step S1009, and the comparing unit 12 compares the partial physical simulation results 500-1 with the measurement model 600-1. As a result of the comparison, it is assumed in this example that, as an actual object difference, a marking line 1FL of the measurement model 600-1 is lower by "d" than the marking line 1FL of the partial physical simulation results 500-1 (FIG. 7B).

In this case, when the processing shifts to Step S1010, the construction instructing unit 13 gives an administrator a construction instruction to directly correct the marking line 1FL drawn on the "actual object of the structure." Specifically, in this example, the construction instructing unit 13 instructs construction details to instruct rewriting of the marking line 1FL by adding a height corresponding to the actual object difference "d" to the marking line 1FL on an actual object 700-1 (FIG. 7B) of the structure. Accordingly, the floor level of the first floor matches the design.

### (Second floor part)

When construction of the "second floor" is completed, the processing shifts to Step S1004 for the second time, and the comparing unit 12 extracts the "first and second floor" parts (that is, reference signs 3001 and 3002 in FIG. 7A) of the initial construction model 300 as a construction completed part model 400-2 from the initial construction database 5 (FIG. 7C). The processing shifts to Step S1005, and the construction completed part model 400-2 is stored in the construction completed part database 6 (FIG. 7C).

The processing shifts to Step S1006, and the comparing unit 12 causes the physical simulation unit 10 to perform a physical simulation for the construction completed part model 400-2 and to calculate partial physical simulation results 500-2 and a marking line 2FL of the results 500-2 (FIG. 7C). In this example, in the partial physical simulation results 500-2, the first floor part slightly contracts due to the weight of the second floor part. The processing shifts to Step S1007, and the partial physical simulation results 500-2 are stored in the partial physical simulation results database 7 (FIG. 7C).

The processing shifts to Step S1008, and the comparing unit 12 obtains a measurement model 600-2 by reading measurement data corresponding to the first and second floor parts after the construction of the second floor from the measurement database 4 (FIG. 7C). The processing shifts to Step S1009, and as a result of comparison by the comparing unit 12, in this example, it is assumed that a marking line 2FL of the measurement model 600-2 is higher by "d" than the marking line 2FL of the partial physical simulation results 500-2 (FIG. 7C).

In this case, when the processing shifts to Step S1010, the construction instructing unit 13 instructs construction details to instruct reduction of the height of the marking line 2FL of an actual object 700-2 (FIG. 7C) of the structure by the actual object difference "d" and rewriting of the marking line 2FL. Accordingly, the floor level of the second floor matches the design.

### (Third floor part)

When construction of the "third floor" is completed, the processing shifts to Step S1004 for the third time, and the comparing unit 12 extracts the "first, second, and third floor" parts (that is, reference signs 3001, 3002, and 3003 in FIG. 7A) of the initial construction model 300 as a construction completed part model 400-3 from the initial construction database 5 (FIG. 7D). The processing shifts to Step S1005, and the construction completed part model 400-3 is stored in the construction completed part database 6 (FIG. 7D).

The processing shifts to Step S1006, and the comparing unit 12 causes the physical simulation unit 10 to perform a physical simulation for the construction completed part model 400-3 and to calculate partial physical simulation results 500-3 and a marking line 3FL of the results 500-3 (FIG. 7D). In this example, the second floor part slightly contracts due to the weight of the third floor, and the first floor part further contracts due to the weight of the second and third floors. The processing shifts to Step S1007, and the partial physical simulation results 500-3 are stored in the partial physical simulation results database 7 (FIG. 7D).

The processing shifts to Step S1008, and the comparing unit 12 obtains a measurement model 600-3 corresponding to the first, second, and third floor parts after the construction of the third floor from the measurement database 4 (FIG. 7D). The processing shifts to Step S1009, and as a result of comparison by the comparing unit 12, in this example, no actual object difference occurs between a height of a marking line 3FL of the partial physical simulation results 500-3 and a height of a marking line 3FL of the measurement model 600-3. That is, the floor level of the third floor matches the design.

As described above, according to the construction management system 1 and the construction management method of the present embodiment, construction deviations in the position of a construction reference line such as a marking line and an auxiliary member to be attached to a constituent member, such as a window frame, can also be corrected. In addition, as mentioned in this example, in the construction management system 1 and the construction management method of the present embodiment, instructions on construction details can be reflected not only in the initial construction model 300 but also in the "actual object of the structure."

### Second Embodiment:

### <Configuration of Construction Management System>

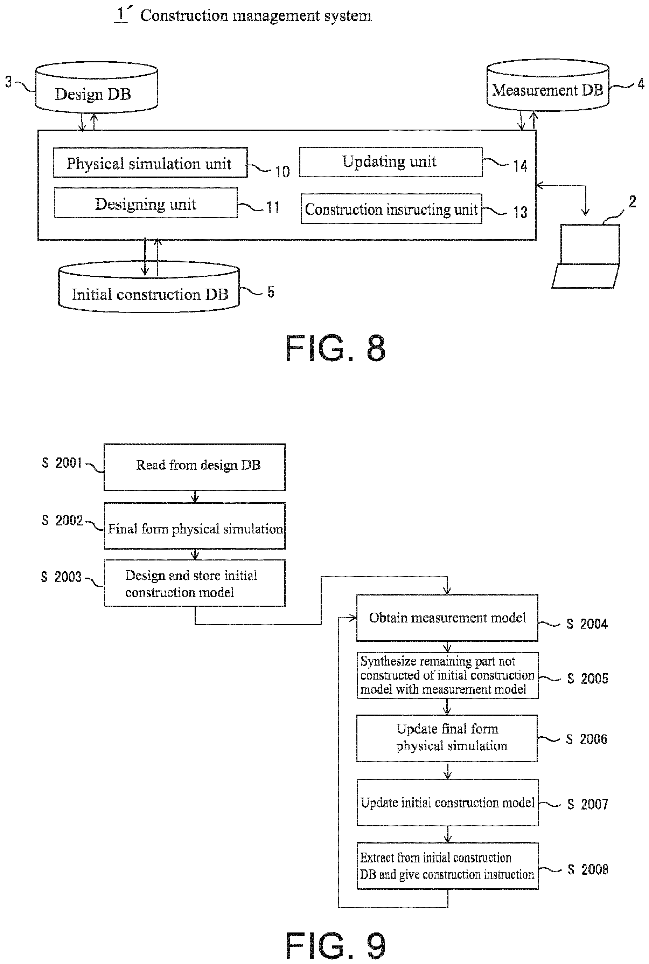

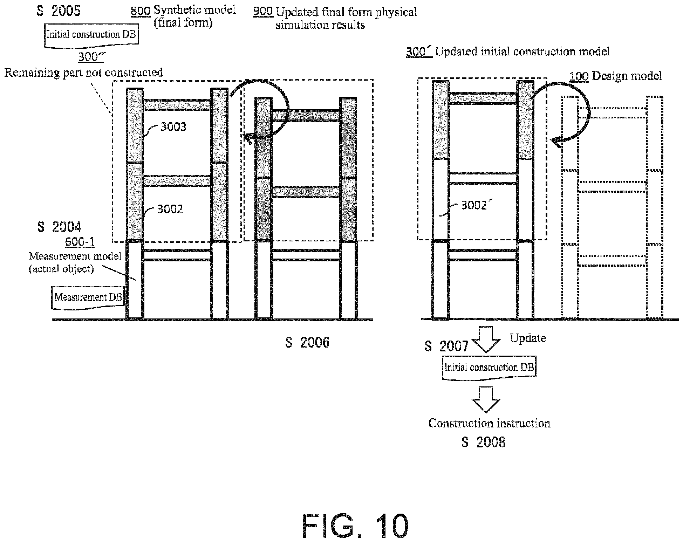

FIG. 8 is a configuration block diagram of a construction management system 1' according to a second embodiment of the present invention, FIG. 9 is a flowchart illustrating a construction management method according to the second embodiment of the present invention, and FIG. 10 is a construction management image of the flow of FIG. 9. For the same configurations as in the first embodiment, the same reference signs and step numbers are used to omit description.

The construction management system 1' of the present embodiment includes an input/output device 2, a design database 3, a measurement database 4, an initial construction database 5, a physical simulation unit 10, a designing unit 11, a construction instructing unit 13, and an updating unit 14.

In the construction management illustrated in the first embodiment, construction details are instructed based on an actual object difference obtained as a result of comparison between simulation results and an actual object. On the other hand, in construction management of the present embodiment, the "initial construction model is updated, based on an actual object (measurement model 600)" and construction details are instructed.

Construction of a three-storied structure will be described by way of example. Steps S2001 to S2003 in FIG. 9 are the same as Steps S1001 to S1003 in FIG. 2. That is, when construction management is started in the present embodiment, in Step S2001, a design model 100 of the entire structure (final form of the structure) is read out from the design database 3, final form physical simulation results 200 are calculated in Step S2002, and in Step S2003, a design difference between the design model 100 and the final form physical simulation results 200 is calculated and an initial construction model 300 is designed. The design work may be repeatedly performed. Finally, through a physical simulation performed therefor, the initial construction model 300 has a relationship of matching the design model 100. The initial construction model 300 is stored in the initial construction database 5.

Next, the processing shifts to Step S2004, and in this embodiment, the updating unit 14 functions. The updating unit 14 reads measurement data from the measurement database 4, and creates a measurement model 600 of a part completely constructed at the present stage. In this example, since the construction has been completed up to the "first floor," it is assumed that a measurement model 600-1 is created (FIG. 10).

Next, the processing shifts to Step S2005, and the updating unit 14 adds a part (hereinafter, referred to as a "remaining part not constructed") 300" that has not been completely constructed at the present stage of the initial construction model 300 stored in the initial construction database 5 to the measurement model 600-1 of the part completely constructed at the present stage, to create a synthetic model 800 of the entire structure (final form of the structure) (FIG. 10). In this example, as the remaining part 300" not constructed, second and third floor parts of the original initial construction model 300, that is, the reference signs 3002 and 3003 in FIG. 4A are synthesized with the measurement model 600-1.

Next, the processing shifts to Step S2006, and the updating unit 14 causes the physical simulation unit 10 to perform a physical simulation for the remaining part 300" not constructed of the synthetic model 800, and updates the final form physical simulation results 200 (hereinafter, the final form physical simulation results 200 having been updated are referred to as "updated final form physical simulation results 900" (FIG. 10) .

Next, the processing shifts to Step S2007, and the updating unit 14 causes the designing unit 11 to calculate a design difference between the design model 100 and the updated final form physical simulation results 900 only for the remaining part 300" not constructed, and updates the initial construction model 300 by considering the design difference in the design model 100 (hereinafter, the initial construction model 300 having been updated is referred to as an "updated initial construction model 300'") . The design work of the updated initial construction model 300' by the designing unit 11 may also be repeatedly performed. Finally, through a physical simulation performed for the remaining part 300" not constructed of the updated initial construction model 300', the updated initial construction model 300' has a relationship of matching the design model 100 (FIG. 10). The updating unit 14 updates the initial construction database 5 so that information on the updated initial construction model 300' is stored.

Next, the processing shifts to Step S2008, and the construction instructing unit 13 extracts a part to be constructed next and/or later from the updated initial construction model 300', and instructs construction details. In this example, a second floor part (that is, the reference sign 3002' in FIG. 10) is extracted from the updated initial construction model 300', and based on information obtained from the construction model 3002' of the second floor part, construction details are instructed.

After the construction instruction is given, the processing in the flow of the construction management method of the present embodiment returns to Step S2004 again. Then, the steps are repeated until construction of the structure is completed (until the final form is obtained).

As described above, according to the construction management system 1' and the construction management method of the present embodiment, a physical simulation is performed for the remaining part 300" not constructed on the premise of the measurement model 600 of the part completely constructed at the present stage, and by "updating the initial construction model," construction details of a part to be constructed next and/or later are instructed. In this pattern also, construction proceeds so that the final form of the structure always matches the design model 100, and construction management can be performed so that the final form of the structure is as designed.

### (Modifications)

Next, preferred modifications of the first and second embodiments described above will be described.

### Modification 1:

Modification 1 relates to the step of designing an "initial construction model 300," and is applicable to either of the first and second embodiments. Hereinafter, application to the first embodiment will be described by way of example.

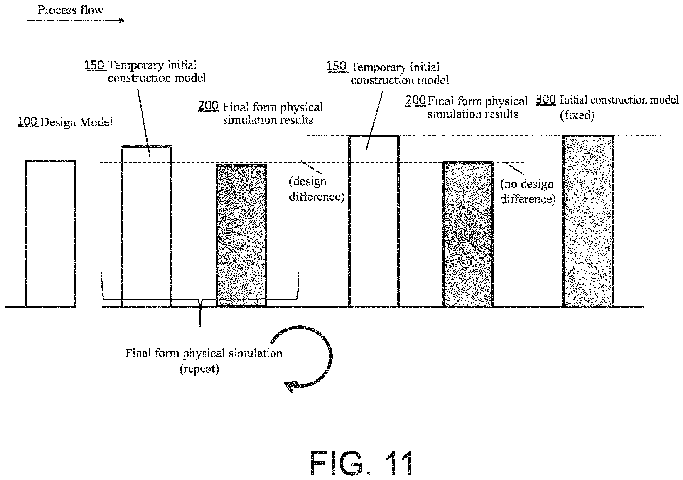

FIG. 11 is a construction management image of Modification 1. In the first embodiment, as described in Steps S1001 to S1003 in FIG. 2, a physical simulation is performed for the "design model 100" and an "initial construction model 300" is designed. The design work is assumed to be repeatedly performed through trial and error.

On the other hand, in Modification 1, as illustrated in FIG. 11, as a tentative and temporary initial construction model before reaching a final initial construction model, a "temporary initial construction model 150 (which is an example of the "model of the structure" in the claims)" is created based on the design model 100. The physical simulation unit 10 first creates a temporary initial construction model 150, and calculates final form physical simulation results 200 by performing a physical simulation (which may be performed multiple times in some cases) for the temporary initial construction model 150, whereby leading to designing of an initial construction model 300. The temporary initial construction model 150 may be roughly created based on experiences of an administrator, etc. , according to estimation, etc., in similar cases. According to Modification 1, by performing the step of creating the temporary initial construction model 150, complicated parameters in one physical simulation can be reduced, and the calculation until the final form physical simulation results 200 match the design model 100 is accelerated, so that designing of the initial construction model 300 can be accelerated.

### Modification 2:

Modification 2 also relates to the step of designing an "initial construction model 300," and is applicable to either of the first and second embodiments. Hereinafter, application to the first embodiment will be described by way of example.

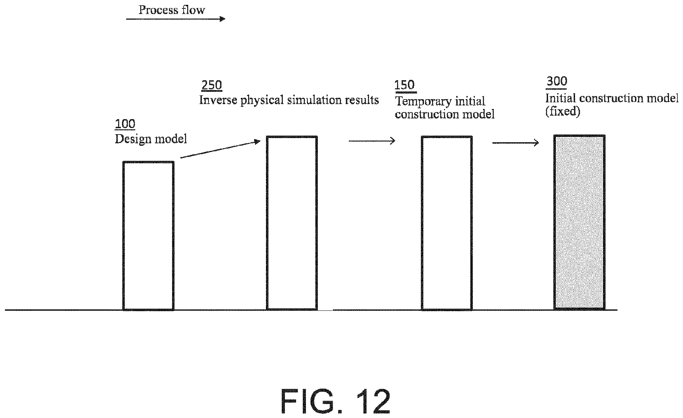

FIG. 12 is a construction management image of Modification 2. In Modification 2, a "temporary initial construction model 150" is created from "inverse physical simulation results 250" obtained by performing an "inverse physical simulation" for the design model 100, and an initial construction model 300 is designed. The inverse physical simulation is performed by inversely transforming a physical simulation, and a calculation result of displacement, stress, distortion, or the like occurring in each constituent member is reflected against a direction of an external force applied to each constituent member. For example, when it is calculated that a certain constituent member contracts by ΔL due to compression by an external force, a work to elongate the constituent member by ΔL is performed.

That is, in Modification 2, as illustrated in FIG. 12, the physical simulation unit 10 prepares "inverse physical simulation results 250" by performing an inverse physical simulation for the design model 100, and designs an "initial construction model 300" from the inverse physical simulation results 250. However, it is also possible to calculate before determining the design, final form physical simulation results 200 by performing a physical simulation (which may be performed multiple times in some cases) by using the inverse physical simulation results 250 as a temporary initial construction model 150 for the initial construction model 300 so that the initial construction model 300 matches the design model 100 through the physical simulation, whereby leading to designing of the initial construction model 300. By performing the inverse physical simulation, a temporary initial construction model 150 can be created even when there is no similar case, and the number of physical simulations in designing of the initial construction model 300 can be reduced by at least one.

### Modification 3:

Modification 3 relates to the step of obtaining a "measurement model 600," and is applicable to either of the first and second embodiments.

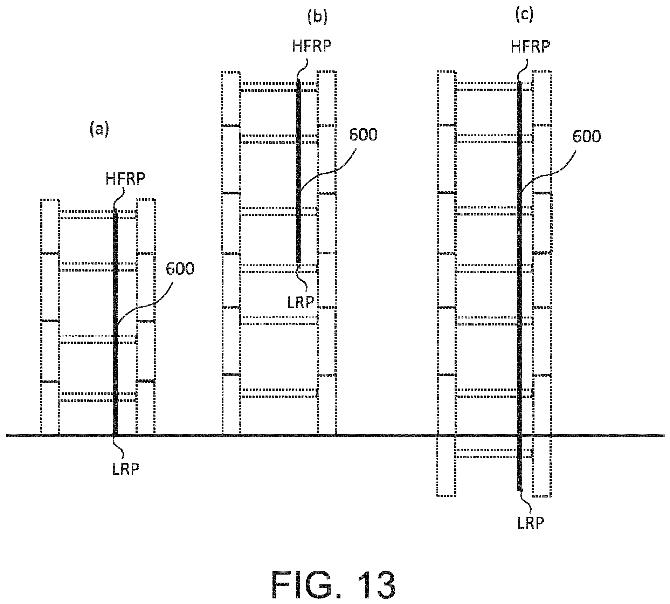

FIG. 13 is a construction management image of Modification 3. In Step S1008 in FIG. 2 of the first embodiment, and in Step S2004 in FIG. 9 of the second embodiment, a measurement model 600 of the structure is obtained from measurement data. For example, referring to FIG. 3 of the first embodiment, for a three-storied structure, all measurement data of the first floor part in FIG. 3B, all measurement data up to the second floor part in FIG. 3C, and all measurement data up to the third floor part in FIG. 3D are used to obtain their respective measurement models 600-1, 600-2, and 600-3.

On the other hand, in Modification 3, as illustrated in FIG. 13, measurement data to be used for obtaining a measurement model 600 are at least absolute coordinates of a lower story reference point LRP and a highest story reference point HFRP of the structure. That is, the measurement model 600 is created based on at least these two points. Measurement data of the lower story reference point LRP and the highest story reference point HFRP may be coordinates in any one direction of the X, Y, and Z directions (for example, only Z representing a height), may be coordinates in combination of any two directions (for example, only X and Y in two-dimensional directions), or may be three-dimensional coordinates (X, Y, Z).

The highest story reference point HFRP is a reference point set in the highest story of a part completely constructed at the present stage, and is set in the fourth floor when construction is completed up to the fourth floor as illustrated in (a) of FIG. 13, and set in the sixth floor when construction is completed up to the sixth floor as illustrated in (b) of FIG. 13. The lower story reference point LRP is a reference point set in a story lower than the story in which the highest story reference point HFRP is set, and may be set in the first floor as illustrated in (a) of FIG. 13, may be set in an intermediate floor as illustrated in (b) of FIG. 13, may be set in a basement floor as illustrated in (c) of FIG. 13, or may be set at a position outside of the building. The highest story reference point HFRP and the lower story reference point LRP may not be on the same vertical axis. For example, when measurement in the vertical direction on an intermediate floor is inevitably difficult, the HFRP and the LRP may be connected through multiple other reference points. The highest story reference point HFRP and the lower story reference point LRP may be set on a floor, a wall, or a ceiling.

Therefore, according to Modification 3, in the first embodiment, the comparing unit 12 obtains a measurement model 600 based on absolute coordinates of the lower story reference point LRP and the highest story reference point HFRP in Step S1008, and in Step S1009, performs comparison at the position of the highest story reference point HFRP. In the second embodiment, the updating unit 14 obtains a measurement model 600 based on absolute coordinates of the lower story reference point LRP and the highest story reference point HFRP in Step S2004, and in Step S2005, performs synthesization at the position of the highest story reference point HFRP.

That is, in Modification 3, for the measurement model 600, even when measurement data of a floor between the lower story reference point LRP and the highest story reference point HFRP cannot be obtained (cannot be measured), construction management according to the embodiment can be performed.

As described above, preferred embodiments and modifications of the present invention have been described, and the embodiments and modifications can be combined based on knowledge of a person skilled in the art, and such combined embodiments are also included in the scope of the present invention.

### [Reference Signs List]

- 1: Construction management system
- 2: Input/output device
- 3: Design database
- 4: Measurement database
- 5: Initial construction database
- 6: Construction completed part database
- 7: Partial physical simulation results database
- 11: Physical simulation unit
- 12: Comparing unit
- 13: Construction instructing unit
- 14: Updating unit
- 100: Design model
- 150: Temporary initial construction model
- 200: Final form physical simulation results
- 250: Inverse physical simulation results
- 300: Initial construction model
- 300': Updated initial construction model
- 300": Remaining part not constructed
- 400: Construction completed part model
- 500: Partial physical simulation results
- 600: Measurement model
- 800: Synthetic model
- 900: Updated final form physical simulation results
- HFRP: Highest story reference point
- LRP: Lower story reference point

## Claims

1. A construction management method comprising the steps of:
by transmitting and receiving information to and from a design database storing a design model of a structure and a measurement database storing measurement data on the structure,
reading the design model of the entire of the structure from the design database;
designing an initial construction model so that final form physical simulation results obtained by performing a physical simulation by applying a physical deformation to a model of the structure match the design model;
obtaining a measurement model from the measurement data of a part completely constructed at the present stage in the measurement database;
creating a synthetic model of the entire structure by adding a part not completely constructed at the present stage of the initial construction model to the measurement model of the part completely constructed at the present stage;
designing an updated initial construction model from updated final form physical simulation results obtained by performing the physical simulation for the synthetic model; and
extracting a part to be constructed next and/or later from the updated initial construction model, and instructing construction details based on the part to be constructed next and/or later of the updated initial construction model.

2. The construction management method according to Claim 1, wherein
the step of designing the initial construction model performs either of
(i) calculating a design difference between the final form physical simulation results obtained by performing the physical simulation for the design model, and the design model, and by considering the design difference in the design model, designing the initial construction model so that the final form physical simulation results match the design model, or
(ii) calculating a design difference between the final form physical simulation results obtained by performing the physical simulation for a temporary initial construction model created based on the design model, and the design model, and by considering the design difference in the design model, designing the initial construction model so that the final form physical simulation results match the design model.

3. The construction management method according to Claim 1, wherein
the step of designing the initial construction model includes
designing the initial construction model from inverse physical simulation results obtained by performing an inverse physical simulation by inversely transforming the physical simulation for the design model.

4. The construction management method according to Claim 1, wherein
the step of obtaining the measurement model includes
reading at least one each of measurement data of a lower story reference point and a highest story reference point of the structure as the measurement data.

5. A construction management system comprising:
a design database storing a design model of a structure;
a measurement database storing measurement data on the structure;
a physical simulation unit configured to perform a physical simulation by applying a physical deformation to a model of the structure;
an initial construction database configured to store an initial construction model designed so that final form physical simulation results obtained by performing the physical simulation match the design model;
a construction completed part database configured to store a construction completed part model obtained by extracting a part completely constructed at the present stage from the initial construction model;
a partial physical simulation results database configured to store partial physical simulation results obtained by performing the physical simulation for the construction completed part model;
a comparing unit configured to calculate an actual object difference by comparing the partial physical simulation results with a measurement model obtained from the measurement data of the part completely constructed at the present stage; and
a construction instructing unit configured to instruct construction details of a part to be constructed next and/or later of the initial construction model or an actual object of the structure.

6. A construction management system comprising:
a design database storing a design model of a structure;
a measurement database storing measurement data on the structure;
a physical simulation unit configured to perform a physical simulation by applying a physical deformation to a model of the structure;
an initial construction database configured to store an initial construction model designed so that final form physical simulation results obtained by performing the physical simulation match the design model;
an updating unit configured to create a synthetic model of the entire of the structure by adding a part not completely constructed at the present stage of the initial construction model to a measurement model obtained from the measurement data of a part completely constructed at the present stage, and design an updated initial construction model from updated final form physical simulation results obtained by performing the physical simulation for the synthetic model; and
a construction instructing unit configured to extract a part to be constructed next and/or later from the updated initial construction model, and instruct construction details based on the part to be constructed next and/or later of the updated initial construction model.

7. A construction management program describing the construction management method according to any of Claims 1 to 6 by a computer program to enable execution of the construction management method.
